# EUROPEAN PATENT APPLICATION

(11) **EP 2 315 248 A1**
(43) Date of publication of application: **27.04.2011**
(21) Application number: 09425428.1
(22) Date of filing: 26.10.2009
(51) Int. Cl.: H01L 27/146

(54) **Method of manufacturing a semiconductor sensor and sensor obtained**

(71) Applicant: Fondazione Bruno Kessler, 38122 Trento (IT)
(72) Inventor: Piemonte, Claudio, 38057 Pergine (IT)
(74) Representative: Borsano, Corrado

(57) **Abstract**

A method of manufacturing a semiconductor sensor consisting of a silicon slice comprising an inactive layer (7), a first face (71) thereof having a sensitive layer (6) attached/formed thereon. The method includes a pre-cutting step on at least one face of the sensor, and a following step of completely cutting in the previously tapered zones. Thereby, the damage zone upon the complete cut of the sensor edge, develops underneath the sensitive layer (6) without degrading the operation thereof. Further manipulations and machining operations on the silicon slice as a whole may be operated between the pre-cutting step and the completely cutting step. At their end, the various sensors are definitively separated by completely cutting the silicon slice.

## Description

### Field of the invention

The present invention relates to a method of manufacturing a semiconductor sensor and the sensor obtained.

### State of the art

A problem affecting the manufacture of sensors consists in cutting the same from the silicon wafer from which they are obtained. The sensors generally comprise a substrate having an inactive silicon layer attached thereto, which has in turn a sensitive layer attached or formed thereon.

At the end of the micro-machining operated in parallel on the sensors obtained from the same silicon slice, the complete cutting of the edges of the various sensors is carried out.

The typical cutting methods normally employ mechanical means such as a saw or a laser, that imply a partial damage of the sensitive layer edge, but also of the inactive layer of the sensor, for this reason a zone of the sensor edge remains damaged due to the formation of cracks and micro-slits upon a cutting operation.

The sensitive part, i.e. the sensor surface on which an electrical signal corresponding to the arrival of a photon is detected, should not be affected by the damage in order not to deteriorate the electrical features of the sensor. Therefore, a matrix or an array of sensors placed side by side comprises inactive zones, at least partially due to the damage of the sensors during the cutting operation.

The wider the extension of the damage inside the sensor, the wider the space wasted in a sensor comprising more elementary sensors or pixels. Such a problem is particularly felt when manufacturing light radiation sensors.

It is known that the cutting operation creates a damaged zone affecting the edge of the cut part over about 100um and the thickness of the inactive layer for an epitaxial silicon is of different hundreds of microns.

### Summary of the invention

It is an object of the present invention to provide a method of manufacturing a semiconductor sensor adapted to solve the aforesaid problem.

It is the subject matter of the present invention a method of manufacturing a semiconductor sensor, in accordance with claim 1, comprising an inactive layer, a first face thereof having a sensitive layer attached/formed thereon, the method comprising a step of pre-cutting by means of physical etching DRIE of at least one face of the sensor and a following step of completely cutting in a pre-cut part.

The pre-cutting operation, i.e. a non-through engraving of the layer, is particularly implemented so that the damage zone resulting from the following complete cutting of the sensor edge, especially if it is carried out by mechanical means, develops under the active layer without deteriorating the efficiency thereof. In other words, said damage zone is confined towards the face opposite the sensitive face of the sensor. After the pre-cutting operation, a silicon slice from which the sensor is obtained, is still advantageously easy to be handled as a whole during the possible following machining operations, until the complete cutting which determines the separation of the different semiconductor sensors obtained from the same silicon slice.

While keeping the thickness of the inactive layer unchanged, the inactive zones of the sensor are advantageously dramatically reduced, this being a particularly important aspect when it should be associated with other similar sensors in matrixes or arrays of sensors.

Said method is particularly applied when manufacturing optical sensors for detecting light, visible, UV, lR radiations, etc.

Said inactive layer comprises a first face having said sensitive layer attached/formed thereon and a second face opposite to said first face, then a tapering operation of the active face only advantageously tends to concentrate said damage zone far from the sensitive face, once the cutting operation has been completed.

Thereby, the extension of said inactive zone may be strongly limited.

According to a preferred variation of the invention, said tapering operation is conducted on the active face of the sensor by DRIE etching (Deep Reactive Ion Etching), since it does not produce any damage of the silicon slice, but whether other techniques with similar results were to be identified, the described method may however be applied.

Said pre-cutting operation may advantageously determine a taper of said face allowing the metal parts intended to collect the electrical signals produced by the sensor to be more easily allocated.

Furthermore, said following step of completely cutting may also be carried out by means of physical etching DRIE.

The dependent claims describe preferred embodiments of the invention, forming an integral part of the present description.

### Brief description of the drawings

Further features and advantages of the invention will be more apparent in view of the detailed description of preferred, but not exclusive, embodiments of a semiconductor sensor for detecting a light radiation, obtained by the manufacturing method object of the present invention.

Said sensor is shown by way of non-limiting example, with the aid of the accompanying drawings, in which:
Figure 1 depicts a first variation of a portion of a sensor in accordance with the present invention, where the per-cut is clear, i.e. the walls are perpendicular to the sensitive face of the sensor;
Figure 2 depicts a cutaway view of a second variation of a portion of a sensor obtained by the present invention, where one edge of said sensor is tapered.

The same reference numerals and letters of the figures identify the same elements or components.

### Detailed description of a preferred embodiment of the invention

A preferred embodiment described below relates to the application of the method object of the present invention having optical sensors capable of detecting a light radiation. However, the inventive concept may be extended to any sensor. Therefore, the method comprises a procedure of physical etching intended to implement a pre-cut, being both clear and intended to taper the edges of the sensors machined and obtained from the same silicon slice.

For this reason said pre-cut may be clear with edges substantially perpendicular to a wider face 71 or 72 of the inactive layer 7, or it may be mitigated.

Said pre-cutting operation may be performed at any moment during a machining process affecting a silicon slice.

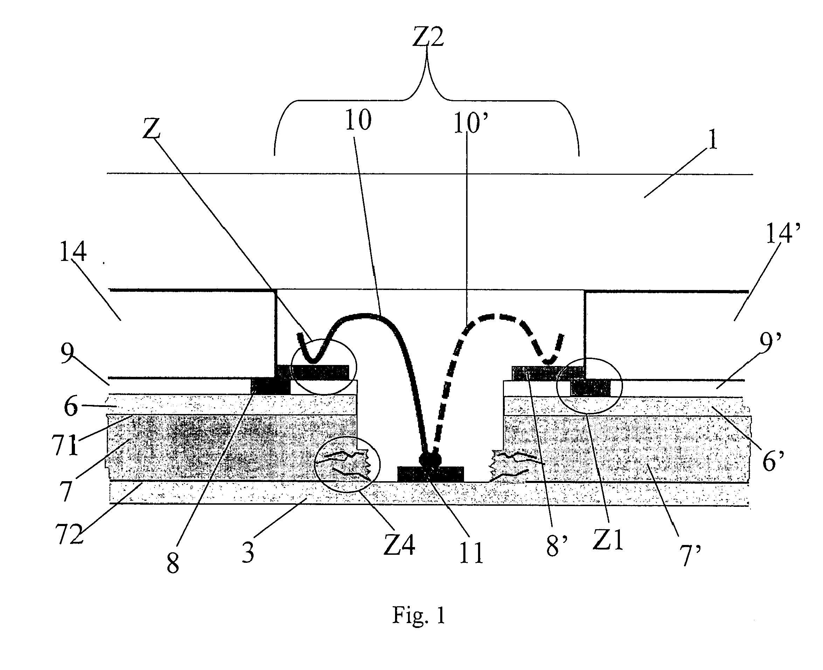

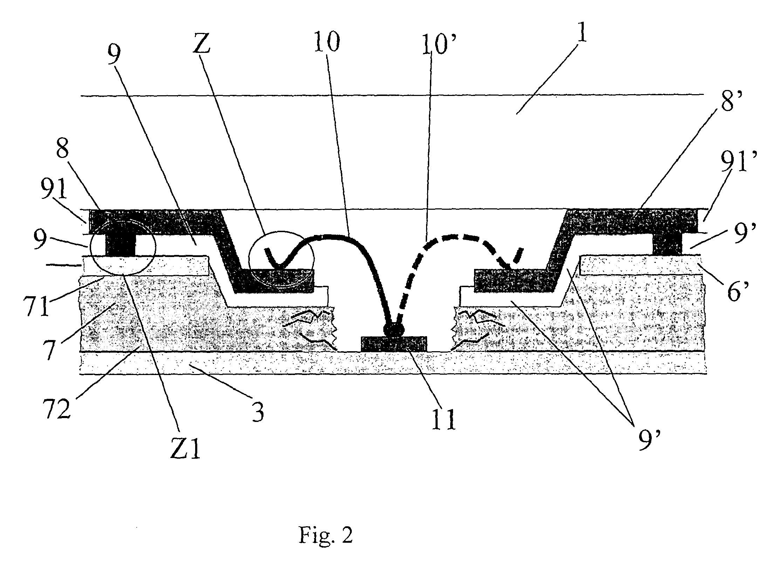

An optical sensor in accordance with the present invention is described with the aid of Figures 1 and 2, in particular it comprises a substrate 3, e.g. common to a plurality of sensors or pixels, an inactive layer 7, a first face 71 thereof having a sensitive layer 6 attached/formed thereon adapted to detect a light radiation. A metal layer 8 is attached to a portion of said sensitive layer 6, adapted to collect the detected signals from the sensitive layer and make them available to the bonding wire.

A dielectric layer 9 covers all the remaining portions of the sensitive layer which are not directly covered by said metal layer 8.

Therefore, said metal layer 8 contacts the sensitive layer 6 in a zone Z1, while for the remaining part thereof it extends over said dielectric layer 9.

An at least initially fluxible layer such as grease or glue or resin 91, may be deposited on dielectric portions 9 up to the level of said metal layer, so as to implement a flat surface on which a scintillator crystal may be attached.

In addition to mechanical functions of filling, such a layer of grease, glue, resin 91 may also carry out optical functions of filtering a light radiation crossing the scintillator.

Substrate 3 in correspondence with at least one edge of the sensor comprises a so-called bonding pad 11 i.e. a metal pad. By forming an arch, the bonding wire 10 connects said metal layer 8 to said bonding pad 11 of the substrate.

For removing the mechanical interference between the bonding wire 10 and the scintillator crystal 1, the portion Z of the metal layer 8 for collecting the electrical signals, according to the sections shown in the variations of Figures 1 and 2, is placed at a lower level with respect to the attaching surface of the scintillator crystal 1, so that said bonding wire does not interfere with the scintillator crystal 1.

A first variation of the invention, schematized in Figure 1, provides for the sensor to be of uniform thickness, while a transparent filler layer 14 having the scintillator crystal 1 applied thereto is applied to the dielectric layer. It is preferred that said filler layer 14 is made of epoxylic material. The thickness of such an epoxylic layer 14 is such to ensure the non-interference between the scintillator crystal 1 and the bonding wire 10. It is preferred that said epoxylic layer completely covers said dielectric layer 9 and possibly only partially said metal layer 8.

The epoxylic layer consists of a photoresist which is deposited one or more times per spinning on the silicon slice when manufacturing the sensor. The epoxylic deposit portions possibly deposited on the portions Z of the metal layer 8 intended to the connection by means of the bonding wire 10 are removed by lithography. The thicknesses of said transparent filler layer of may range from 20 to 200um. The transparence of the deposited layers is higher than 90% on the whole spectrum of visible light.

In the preferred variation of Figure 2, said sensor displays a reduction of its thickness in relation to the first face 71 having the sensitive layer 6 of the sensor attached/formed thereon, while the second face 72, opposite to said first face 71, is flat. By covering it, the dielectric layer 9 follows the valley obtained in the first face 71 of the inactive layer 7. The metal layer 8 also follows such a valley spacing out from scintillator 1.

In both the preferred embodiments, while continuing to form an arch, the bonding wire connects the metal layer 8 to the bonding pad 11, attached to substrate 3, without interfering with the scintillator crystal 1 overlapping the sensor.

It is preferred that said valley, or equally said transparent filler layer 14 measures at least 100um for allowing the bonding wire to be easily placed.

The two solutions may be combined with each other, thus implementing a less tapered zone in the inactive thickness 7 and a cover with filling layer 14 of more modest thickness, for example.

In both cases, the pre-cutting operation determines the damage zone Z4 to be moved away from the sensitive face/layer 6.

By means of the method object of the present invention, not only the problem of confining the damage zone Z4 of the sensor far from the sensitive layer 6 is advantageously solved, so that the extension of the inactive zone Z2 may be reduced, but also the problem of the interference between the bonding wire and the scintillator crystal is solved.

According to the present invention, in order to reduce the inactive zone Z2 between two adjacent pixels or pixel rows, a physical etching DRlE is used, preferably during the manufacturing process. Said etching may be carried out both for pre-cutting/tapering the inactive layer 7, and completing the wafer cutting after further machining operations. Such an operation of cutting completion may be alternatively performed by means of a mechanical action, i.e. a saw or a shearing machine, or by means of a laser.

A DRlE etching advantageously allows deep grooves to be performed in the silicon, thus obtaining highly vertical peripheral walls and causing a damage limited to a few microns from the edge. In order to maximize the simplification of the manufacturing process, it is preferred to carry out a partial cut o pre-cut with such a DRIE technique over a depth of at least d=100÷200um underneath said sensitive layer 6.

A further advantage of completely cutting the sensor by means of DRIE is that it allows an elementary sensor to be shaped with shapes other than the rectangular shape. In particular, by employing the DRIE technique, both for pre-cutting and completing the cut of the silicon, shapes adapted to reduce said inactive zones may be obtained, thus optimizing the ratio of the active and total areas.

The circular shape is particularly advantageous because the percentage of inactive zones may be so reduced. Alternative shapes are however easy to be obtained in accordance with the description of the present invention.

The elements and features disclosed in the various preferred embodiments may be combined without departing, however, from the scope of protection of the present application.

## Claims

1. A method of manufacturing a semiconductor sensor comprising an inactive layer (7), a first face (71) thereof having a sensitive layer (6) attached/formed thereon, the method comprising a step of pre-cutting by means of physical etching (DRIE) of at least one face of the sensor, and a following step of completely cutting in a pre-cut part.

2. A method according to claim 1, wherein said pre-cut is clear having clear edges perpendicular to a wider face (71 or 72) of the sensor.

3. A method according to claim 1 or 2, wherein said pre-cut forms a tapering of the sensor edge.

4. A method according to one of the preceding claims, wherein said complete cutting operation is mechanically carried out, by means of a laser or of a further physical etching DRIE.

5. A method according to one of the preceding claims, wherein a depth of at least 100÷200um underneath said sensitive layer (6).

6. A manufacturing method according to one of the preceding claims, wherein said sensor is an optical sensor for detecting a light radiation; said sensor comprising an inactive layer (7), a first face (71) thereof having a sensitive layer (6) attached/formed thereon, a metal layer (8) being attached at least in a portion (Z1) of said sensitive layer (6), at least one bonding wire (10) bending towards said substrate (3) branching from one side (Z) of said metal layer, a scintillator (1) overlapping said sensitive layer (6).

7. A sensor obtained according to any one of the preceding claims.
